(19) Europäisches Patentamt
European Patent Office
Office européen des brevets

(11) **EP 2 187 517 B1**

(12) **EUROPEAN PATENT SPECIFICATION**

(45) Date of publication and mention
of the grant of the patent:
**03.04.2013 Bulletin 2013/14**

(21) Application number: **07828986.5**

(22) Date of filing: **02.10.2007**

(51) Int Cl.:
*H03D 7/18* (2006.01)     *H03D 7/16* (2006.01)
*H03C 7/00* (2006.01)

(86) International application number:
**PCT/JP2007/069246**

(87) International publication number:
**WO 2009/044451 (09.04.2009 Gazette 2009/15)**

(54) **IMAGE REJECTION MIXER AND WIRELESS COMMUNICATION DEVICE**

MISCHER MIT SPIEGELFREQUENZUNTERDRÜCKUNG UND DRAHTLOSES
KOMMUNIKATIONSGERÄT

MÉLANGEUR À RÉJECTION D'IMAGE ET DISPOSITIF DE COMMUNICATION SANS FIL

(84) Designated Contracting States:
**AT BE BG CH CY CZ DE DK EE ES FI FR GB GR
HU IE IS IT LI LT LU LV MC MT NL PL PT RO SE
SI SK TR**

(43) Date of publication of application:
**19.05.2010 Bulletin 2010/20**

(73) Proprietor: **Mitsubishi Electric Corporation
Tokyo 100-8310 (JP)**

(72) Inventors:
• **KAWAKAMI, Kenji
Tokyo 100-8310 (JP)**
• **TSURU, Masaomi
Tokyo 100-8310 (JP)**
• **MIZUTANI, Hiroyuki
Tokyo 100-8310 (JP)**
• **KITSUKAWA, Yusuke
Tokyo 100-8310 (JP)**

(74) Representative: **Pfenning, Meinig & Partner GbR
Patent- und Rechtsanwälte
Theresienhöhe 13
80339 München (DE)**

(56) References cited:
**EP-A1- 0 952 664      JP-A- 2003 163 601
JP-A- 2006 217 460     US-A- 5 416 449
US-A1- 2003 013 426    US-B1- 6 725 029**

• **KENJI KAWAKAMI ET AL.: 'Image Rejection
Mixer ni Okeru Rejection-ryo no Kaiseki' 1998
NEN ELECTRONICS SOCIETY TAIKAI KOEN
RONBUNSHU 1 07 September 1998, page 58**

**Description**

Technical Field

The present invention relates to an image rejection mixer and a wireless communication device such as a communication device or a radar device that uses the image rejection mixer.

Background Art

As a conventional art, there is an image rejection mixer that performs distribution of a radio frequency (hereinafter, referred to as RF) signal with a 90 degrees hybrid circuit and performs in-phase distribution of a local oscillator (hereinafter, referred to as LO) power with a Wilkinson power distributor. In addition, there is a harmonic mixer for extracting intermediate frequency (hereinafter, referred to as IF) signal and RF signal components by using an antiparallel diode pair in which diodes are connected to each other at reversed polarity (see Non-Patent Document 1).

Non Patent Document 1: Masayoshi Aikawa, Takashi Ohira, Tsuneo Tokumitsu, Tetsuo Hirota, and Mashiro Muraguchi, "Monolithic microwave integrated circuit (MMIC)", The Institute of Electronics, Information and Communication Engineers, January 25th, 1995 first edition, Page 118-119 and Page 120-122. Another mixer is known from JP-2003-163601.

Disclosure of the Invention

Problem to be solved by the Invention

The conventional image rejection mixer is used for a main purpose of suppressing an image signal, but there is a problem that a lot of unwanted frequency components exist at the vicinity of a certain RF frequency as a desired wave in the case of a harmonic mixer.

The present invention is created in view of the above-mentioned problem, and it is an object of the present invention to provide an image rejection mixer and a communication device that may suppress unwanted frequency components of a high power output assuming a fourth-order harmonic mixer.

Means for solving the Problems

The present invention provides image rejection mixers according to claims 1 and 2.

Further, a wireless communication device according to the present invention is the image rejection mixer using the above-mentioned structure.

Effects of the Invention

According to the present invention, a 90-degree LO distributor having a phase difference of 90 degrees is used instead of an LO distributor in a structure of the conventional image rejection mixer so that unwanted frequency components of a high power output may be suppressed.

Brief Description of the Drawings

FIG. 1 is a block diagram illustrating a structure of an image rejection mixer according to Embodiment 1 of the present invention.

FIG. 2 is an output spectrum diagram illustrating a conventional mixer for comparison with Embodiment 1 of the present invention.

FIG. 3 is an output spectrum diagram in an image rejection mixer of a conventional example having a structure using an even harmonic mixer with an APDP, for comparison with the image rejection mixer according to Embodiment 1 of the present invention.

FIG. 4 is an output spectrum diagram illustrating an effect of the image rejection mixer according to Embodiment 1 of the present invention.

FIG. 5 is a block diagram illustrating a structure of an image rejection mixer according to Embodiment 2 of the present invention.

FIG. 6 is a block diagram illustrating a structure of an image rejection mixer according to Embodiment 3 of the present invention.

FIG. 7 is a block diagram illustrating a structure of an image rejection mixer according to Embodiment 4 of the present invention.

FIG. 8 is a block diagram illustrating a structure of a communication device according to Embodiment 5 of the present invention.

Best Mode for carrying out the Invention

Embodiment 1

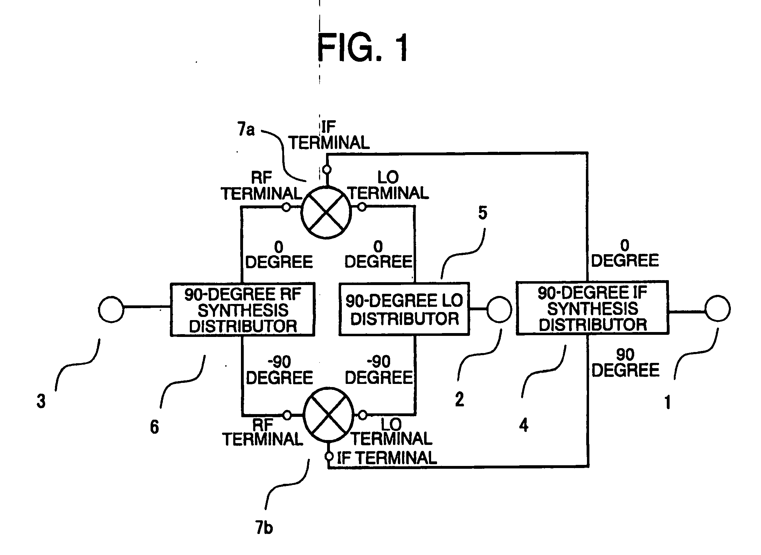

FIG. 1 is a block diagram illustrating a structure of an image rejection mixer according to Embodiment 1 of the present invention. The image rejection mixer illustrated in FIG. 1 includes first and second fourth-order harmonic mixers 7a and 7b that output an RF as a mixed wave of a fourth order component of an input LO signal frequency and an IF first order component, or an IF as a mixed wave of the even order component of the input LO signal frequency and an RF first order component as a desired wave, a 90-degree IF synthesis distributor 4 which distributes and outputs an input signal at a first terminal from second and third terminals with a phase difference of 90 degrees, or synthesizes an input signal at the second terminal and an input signal at the third terminal after delaying a phase of the signal at the second terminal by 90 degrees and outputs the synthesized signal from the first terminal, a 90-degree LO distributor 5 which distributes and outputs an input signal at a first terminal from second and third terminals with a phase difference of 90 degrees, and a 90-degree RF synthesis distributor 6 which distributes and outputs an input signal at a first terminal from second and third terminals with a phase difference of 90 degrees and outputs from the third terminal a signal having a phase delay of 90 degrees with respect to a phase output from the second terminal, or synthesizes an input signal at the second terminal with an input signal at the third terminal after leading a phase of the signal at the second terminal by 90 degrees and outputs the synthesized signal from the first terminal. In FIG. 1, reference numeral 1 denotes an IF signal input and output terminal, reference numeral 2 denotes an LO signal input terminal, and reference numeral 3 denotes an RF signal input and output terminal.

In this case, the second terminal of the 90-degree IF synthesis distributor 4 is connected to an IF terminal of the first fourth-order harmonic mixer 7a, the third terminal of the 90-degree IF synthesis distributor 4 is connected to an IF terminal of the second fourth-order harmonic mixer 7b, the second terminal of the 90-degree LO distributor 5 is connected to an LO terminal of the first fourth-order harmonic mixer 7a, the third terminal of the 90-degree LO distributor 5 is connected to an LO terminal of the second fourth-order harmonic mixer 7b, the second terminal of the 90-degree RF synthesis distributor 6 is connected to an RF terminal of the first fourth-order harmonic mixer 7a, and the third terminal of the 90-degree RF synthesis distributor 6 is connected to an RF terminal of the second fourth-order harmonic mixer 7b.

Next, an operation is described. The present invention uses, similarly to the conventional example, the first and the second fourth-order harmonic mixers 7a and 7b that input the IF signal and the LO signal and extract frequency components of $\pm$IF+4$\times$LO by using a nonlinear element such as an antiparallel diode pair (hereinafter, referred to as APDP) in which diodes are connected antiparallel to each other so that unwanted frequency components are suppressed by this connection method.

A transmission system is exemplified for description. Note that the 90-degree IF synthesis distributor 4 operates as a 90-degree IF distributor and the 90-degree RF synthesis distributor 6 operates as a 90-degree RF synthesizer in the transmission system. A signal input from the IF input and output terminal 1 is distributed by the 90-degree IF synthesis distributor 4 with a phase difference of 90 degrees and is input to the two mixers 7a and 7b. In this case, it is supposed that a phase of the signal input to the second mixer 7b leads 90 degrees to a phase of the signal input to the first mixer 7a.

In addition, the LO signal input from the LO input terminal 2 is distributed by the 90-degree LO distributor 5 with a phase difference of 90 degrees and is input to the two mixers 7a and 7b. In this case, it is supposed that a phase of the LO signal input to the second mixer 7b is delayed by 90 degrees to a phase of the LO signal input to the first mixer 7a.

In the first mixer 7a, the input LO signal and IF signal are mixed so that a mixed wave of A times a frequency of the LO signal frequency and B times a frequency of the IF signal frequency is output. Here, each phase of the LO signal and the IF signal input to the first mixer 7a is regarded as a reference (0 degree). Then, a phase of the output signal component (A$\times$LO+B$\times$IF) is 0 degree.

Similarly, also in the second mixer 7b, the LO signal and the IF signal are mixed so that a mixed wave of A times a frequency of the LO signal frequency and B times a frequency of the IF signal frequency is output. A phase of the IF signal input to the second mixer 7b is +90 degrees with respect to the phase of the IF signal input to the first mixer 7a, and a phase of the LO signal is -90 degrees. Therefore, a phase of the output signal component (A$\times$LO+B$\times$IF) is as follows.

$$A×(-90)+B×90 \text{ degrees} \qquad (1)$$

The signals output from the two mixers 7a and 7b are synthesized in the 90-degree RF synthesis distributor 6 and output from an RF terminal 3. Here, when the signal from the second mixer 7b is delayed by a phase of 90 degrees and is synthesized with the signal from the first mixer 7a, a phase φ of the synthesized signal is as follows.

$$\varphi=-90+A×(-90)+B×90$$

$$=90×(B-A-1) \qquad (2)$$

When this phase φ becomes "0 degree" or "multiple of 360 degrees", the in-phase synthesis is performed so that a maximum power may be extracted. If it is a "180 degrees + multiple of 360 degrees", it is suppressed by the opposite phase synthesis.

(The case of fourth-order harmonic mixer)

It is understood that the RF signal components of the desired wave have A=4, B=1, and φ=-360 degrees, and are synthesized in phase, while image frequencies have A=4, B=-1, and φ=-540 degrees, and are synthesized in opposite phase, which operates as an image rejection mixer.
Further, as an example of the harmonic components that are output at the vicinity of the desired wave, components of relatively low order and relatively high output level such as 2LO+IF (= -180 degrees), 2LO-3IF (= -540 degrees), 3LO+2IF (= -180 degrees), 3LO-2IF (= -540 degrees), 4LO+3IF (=-180 degrees), 5LO(= -540 degrees), 5LO-4IF (-900 degrees), and 6LO-3IF (= -900 degrees) are also synthesized in opposite phase and may be suppressed in theory.
In this way, the structure has an effect of suppressing in theory undesired waves generated by a combination of the LO signal frequency and the IF signal frequency to be φ=180+360N (N is an integer) illustrated in the equation (2) like 2LO+IF, 3LO+2IF, 5LO, or the like, in which image rejection function remains. The mixer uses a fourth order of the LO signal, and hence even if the LO signal has a difference of 90 degrees, a phase difference of the 4LO signal component in the two mixers becomes 360 degrees = 0 degree. As to the desired wave and the image wave, the same operation as the conventional operation may be performed, and it may be said that the structure is unique to the fourth-order harmonic mixer.
As a concrete example, a list of spurious is shown in Table 1.

[Table 1]

| | | LO order | IF order | RF | φ | Suppressed by IRM/APDP | Suppressed by this structure |
|---|---|---|---|---|---|---|---|
| | | | | | | LO=13GHz, IF=2GHz | |
| a | | 4 | -4 | 44 | -810 | o | |
| b | | 3 | 3 | 45 | -90 | o | |
| c | | 4 | -3 | 46 | -720 | | |
| d | | 3 | 4 | 47 | 0 | | |
| e | | 4 | -2 | 48 | -630 | o | |
| f | | 3 | 5 | 49 | 90 | o | |
| g | | 4 | -1 | 50 | -540 | o Image wave | o |
| h | | 4 | 0 | 52 | -450 | o | |
| i | | 4 | 1 | 54 | -360 | Desired wave | |
| j | | 5 | -5 | 55 | -990 | o | |
| k | | 4 | 2 | 56 | -270 | o | |
| l | | 5 | -4 | 57 | -900 | | o |
| m | | 4 | 3 | 58 | -180 | | o |

4

(continued)

| | LO order | IF order | RF | φ | Suppressed by IRM/APDP | Suppressed by this structure |
|---|---|---|---|---|---|---|
| | | | LO=13GHz, IF=2GHz | | | |
| n | 5 | -3 | 59 | -810 | o | |
| 0 | 4 | 4 | 60 | -90 | o | |
| p | 5 | -2 | 61 | -720 | | |
| q | 4 | 5 | 62 | 0 | | |
| r | 5 | -1 | 63 | -630 | o | |

It is supposed that LO signal frequency is 13 GHz, IF signal frequency is 2 GHz, LO signal order is four. The fourth-order harmonic mixer is considered to have a desired wave of 54 GHz that is an output frequency when the IF signal order is one. Components of mixed waves that exist at the vicinity of the desired wave ($\pm$10 GHz) are shown. Here, the upper limit of the order of the LO signal and the order of the IF signal is five. There are 18 frequency components including the desired wave.

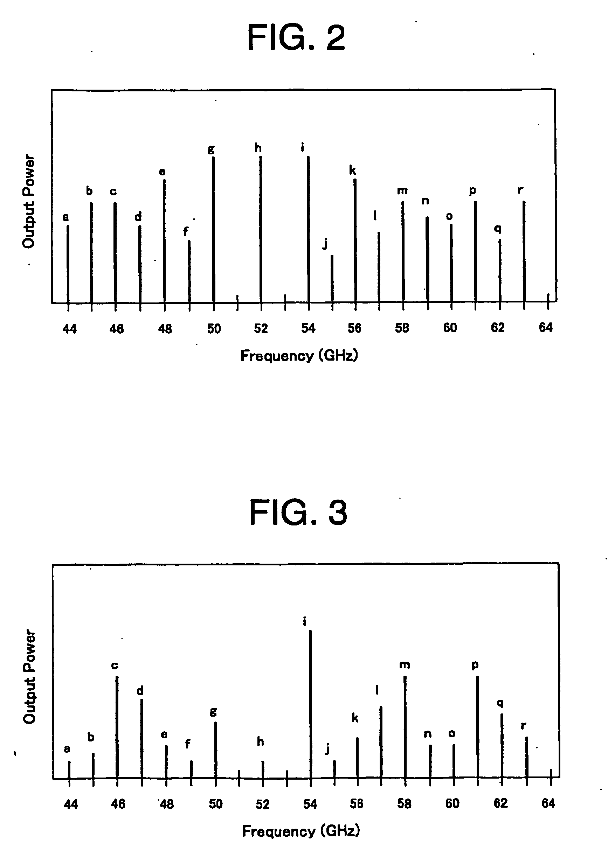

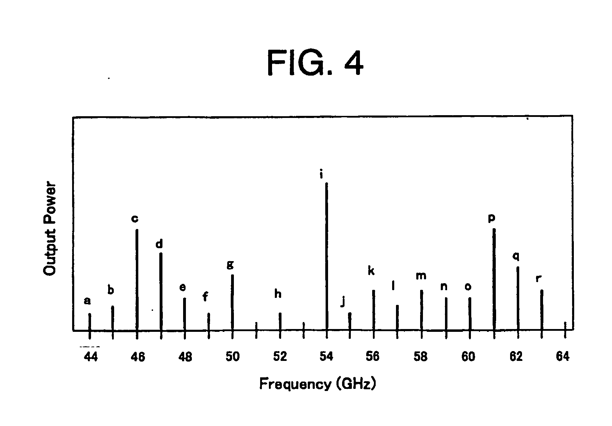

FIG. 2 illustrates spectrum characteristics of the conventional mixer, in which the horizontal axis represents frequency (GHz) and the vertical axis represents output power. FIG. 3 illustrates output spectrum in the conventional image rejection mixer having a structure using an even harmonic mixer with an APDP. Further, FIG. 4 illustrates output spectrum in the case of the structure described as Embodiment 1 in which the APDP is used for the first and the second fourth-order harmonic mixers 7a and 7b, and further the 90-degree LO distributor 5 for distributing an output having a phase difference of 90 degrees is used for an LO frequency distributor.

As illustrated in FIG. 3, the APDP suppresses a wave having an even sum of the order of the LO signal and the order of the IF signal. In addition, according to this structure, as illustrated in FIG. 4, if the equation (2) is "180 degrees + multiple of 360 degrees", it is suppressed by the opposite phase synthesis. Therefore, a spurious component at the very vicinity of the desired wave is suppressed. There is an effect of allowing specifications required to the filter after the mixer to be relieved.

Specifically, in the case of FIG. 2, there are a lot of spurious of high output power at the vicinity of desired 54 GHz, and the even harmonic mixer using the APDP suppresses a wave having an even sum of the order of the LO signal and the order of the IF signal as illustrated in FIG. 3. However, the components l and m that are apart from the desired wave (component i in FIG. 3) by 3 GHz or 4 GHz are not suppressed. Therefore, a steep filter for suppressing the components l and m is necessary. If this embodiment is used, as illustrated in FIG. 4, the components are suppressed, and hence there is an effect of allowing the specification required to the steep filter to be relieved.

Although the case of the transmission system is described above, the case of the reception system also has the same effect.

Embodiment 2

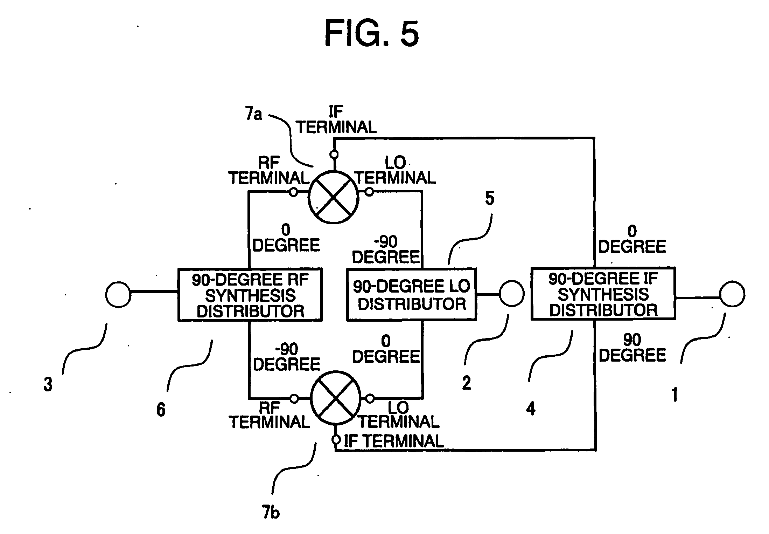

FIG. 5 is a block diagram illustrating a structure of an image rejection mixer according to Embodiment 2 of the present invention. In FIG. 5, the same portion as that in FIG. 1 is denoted by the same reference symbol so that overlapping description thereof is omitted. Embodiment 2 illustrated in FIG. 5 is different from Embodiment 1 illustrated in FIG. 1 in that the 90-degree LO distributor 5 in Embodiment 1 outputs from the third terminal a signal having a phase delay of 90 degrees with respect to the phase output from the second terminal, while the 90-degree LO distributor 5 in Embodiment 2 outputs the signal having the phase delay of 90 degrees with respect to the phase output from the third terminal from the second terminal.

An operation of the image rejection mixer according to Embodiment 2 is similar to that in Embodiment 1. When the 90-degree RF synthesis distributor 6 synthesizes the signals from the two mixers 7a and 7b, the phase φ of the synthesized wave becomes as follows.

$$\varphi = -90 + A \times (90) + B \times 90$$

$$= 90 \times (A + B - 1) \qquad (3)$$

When this phase φ becomes "0 degree" or "multiple of 360 degrees", the in-phase synthesis is performed so that a maximum power may be extracted. If it is a "180 degrees + multiple of 360 degrees", it is suppressed by the opposite phase synthesis.

(The case of fourth-order harmonic mixer)

It is understood that the RF signal components of the desired wave have A=4, B=1, and φ=360 degrees, and are synthesized in phase, while image frequencies have A=4, B=-1, and φ=180 degrees, and are synthesized in opposite phase, which operates as an image rejection mixer.

Further, as an example of the harmonic components that are output at the vicinity of the desired wave, components of relatively low order and relatively high output level such as 2LO+IF (= 180 degrees), 2LO-3IF (= 180 degrees), 3LO+4IF (= 540 degrees), 3LO-4IF (= -180 degrees), 4LO+3IF (= 540 degrees), and 5LO+2IF (540 degrees) are also synthesized in opposite phase and may be suppressed in theory.

In addition, the effect is also the same as that in Embodiment 1. A spurious component appearing at the vicinity of the desired wave depends on a selection method of the LO signal frequency and the IF signal frequency. Therefore, if Embodiment 1 or Embodiment 2 is selected in accordance with the spurious component to be suppressed, higher effect may be obtained.

Although the case of the transmission system is described above, the case of the reception system also has the same effect.

Embodiment 3

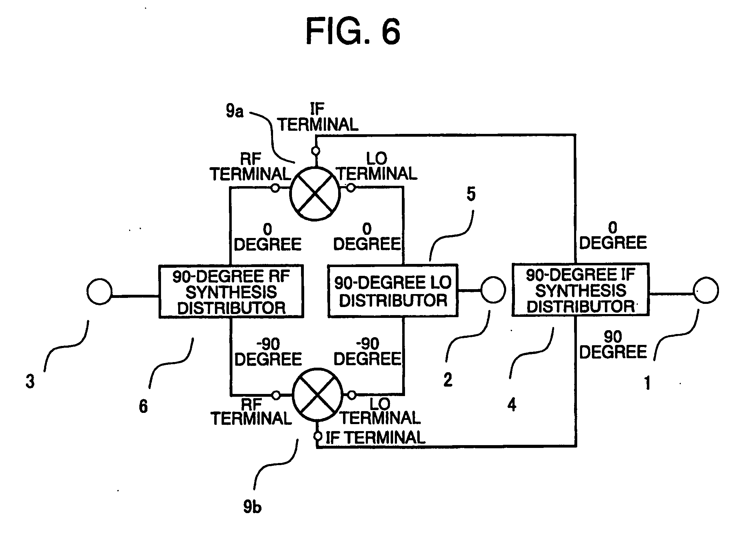

FIG. 6 is a block diagram illustrating a structure of an image rejection mixer according to Embodiment 3 of the present invention. In FIG. 6, the same portion as that in FIG. 1 is denoted by the same reference symbol so that overlapping description thereof is omitted. Embodiment 3 illustrated in FIG. 6 is different from Embodiment 1 illustrated in FIG. 1 in that the first and the second fourth-order harmonic mixers are 4n-th order harmonic mixers 9a and 9b that output the RF as a mixed wave of the 4n-th (n is an integer except 0) order component of the input LO signal frequency and the IF first order component.

An operation of the image rejection mixer according to Embodiment 3 is similar to that illustrated in Embodiments 1 and 2. When described in accordance with Embodiment 1, the phase φ of the wave synthesized by the 90-degree RF synthesis distributor 6 becomes as follows.

$$\varphi = -90 + A \times (-90) + B \times 90$$

$$= 90 \times (B-A-1) \qquad\qquad (4)$$

When this phase φ becomes "0 degree" or "multiple of 360 degrees", the in-phase synthesis is performed so that a maximum power may be extracted. If it is a "180 degrees + multiple of 360 degrees", it is suppressed by the opposite phase synthesis.

In this way, according to this structure, as to multiple of the fourth order, there is an effect of allowing image rejection function to remain while suppressing in theory undesired waves generated by a combination of the LO frequency and the IF frequency to be φ=180+360n illustrated in the equation (4). The mixer uses the 4n-th order of the LO, and hence even if the LO has a difference of 90 degrees, a phase difference of the 4n-th order LO component in the two mixers becomes 360×n=0 degree. Therefore, the desired wave and the image wave may operate similarly to those in the conventional example.

Although the case of the transmission system is described above, the case of the reception system also has the same effect.

Embodiment 4

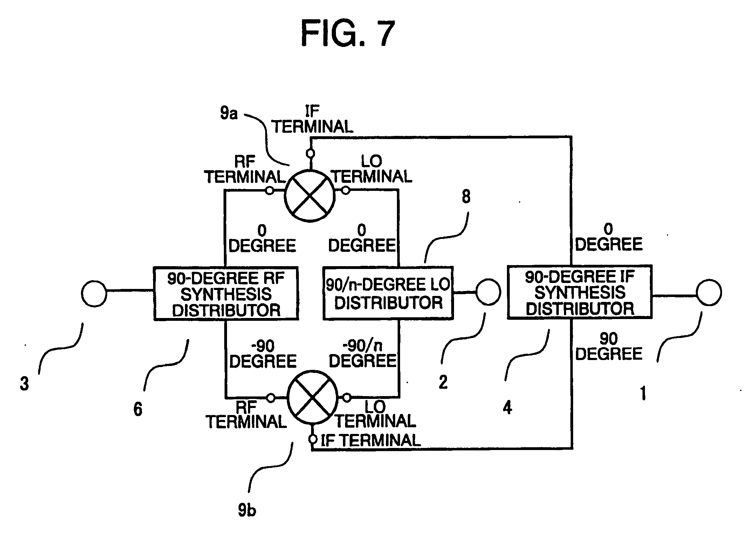

FIG. 7 is a block diagram illustrating a structure of an image rejection mixer according to Embodiment 4 of the present invention. In FIG. 7, the same portion as that in FIG. 6 is denoted by the same reference symbol so that overlapping description thereof is omitted. Embodiment 4 illustrated in FIG. 7 is different from Embodiment 3 illustrated in FIG. 6 in that a 90/n (n is an integer except 0) degree distributor 8 is used as the 90-degree LO distributor.

An operation of the image rejection mixer according to Embodiment 4 is similar to that illustrated in Embodiments 1 to 3. When described in accordance with Embodiment 1, the phase φ of the wave synthesized by the 90-degree RF synthesis distributor 6 becomes as follows.

$$\varphi = -90 + A \times (-90n) + B \times 90$$

$$= 90 \times (B - A/n - 1) \qquad (5)$$

When this phase $\varphi$ becomes "0 degree" or "multiple of 360 degrees", the in-phase synthesis is performed so that a maximum power may be extracted. If it is a "180 degrees + multiple of 360 degrees", it is suppressed by the opposite phase synthesis.

Although the case of the transmission system is described above, the case of the reception system also has the same effect.

Embodiment 5

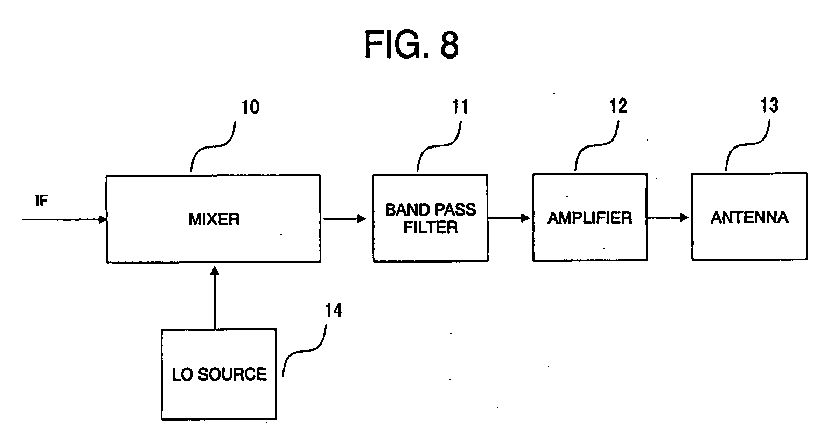

FIG. 8 is a block diagram illustrating a structure of a wireless communication device according to Embodiment 5 of the present invention. The wireless communication device illustrated in FIG. 8 is an example of the case in which an image rejection mixer 10 described above in Embodiments 1 to 4 is used for constituting a transmission unit of a communication device or a radar device. After the mixer 10, a band pass filter 11 suppresses a spurious component output by the mixer 10, an amplifier 12 amplifies the signal to a desired power, and an antenna 13 radiates the signal. Note that reference numeral 14 denotes an LO source. In this case, if the band pass filter 11 is steep, loss in the band increases, and hence a gain required to the amplifier 12 is increased according to the loss. The specification required to the band pass filter 11 may be relieved, and the loss is decreased by using the mixer described above in Embodiments 1 to 4, and hence the specification required to the amplifier 12 is also relieved as a merit.

**Claims**

1.  An image rejection mixer, comprising:

    first and second 4-nth-order harmonic mixers (7a, 7b), each including an LO terminal, an IF terminal, and an RF terminal, and outputs, as a desired wave, an RF as a mixed wave of a 4- nth order component, n is an integer except 0, of an input LO signal frequency and a first order component of an IF,
    a 90-degree IF synthesis distributor (4) which distributes and outputs an input signal at a first terminal from second and third terminals with a phase difference of 90 degrees,
    a 90/n-degree LO distributor (5), n is an integer except 0, which distributes and outputs an input signal at a first terminal from second and third terminals with a phase difference of 90/n degrees; and
    a 90-degree RF synthesis distributor (6) which synthesizes an input signal at a second terminal with an input signal at a third terminal after leading a phase of the input signal at the second terminal by 90 degrees and outputs the synthesized signal from the first terminal, wherein:

       the second terminal of the 90-degree IF synthesis distributor (4) is connected to the IF terminal of the first 4-nth-order harmonic mixer (7a);
       the third terminal of the 90-degree IF synthesis distributor (4) is connected to the IF terminal of the second 4-nth -order harmonic mixer (7b);
       the second terminal of the 90/n-degree LO distributor (5) is connected to the LO terminal of the first 4-nth -order harmonic mixer (7a);
       the third terminal of the 90/n-degree LO distributor (5) is connected to the LO terminal of the second 4-nth -order harmonic mixer (7b);
       the second terminal of the 90-degree RF synthesis distributor (6) is connected to the RF terminal of the first 4-nth -order harmonic mixer (7a); and
       the third terminal of the 90-degree RF synthesis distributor (6) is connected to the RF terminal of the second 4-nth -order harmonic mixer (7b).

2.  An image rejection mixer, comprising:

    first and second 4-nth-order harmonic mixers (7a, 7b), n is an integer except 0, each including an LO terminal, an IF terminal, and an RF terminal, and outputs, as a desired wave, the IF as a mixed wave of an 4-nth order component, n is an integer except 0, of the input LO signal frequency and a first order component of the RF;
    a 90-degree IF synthesis distributor (4) which synthesizes an input signal at a second terminal and an input signal at a third terminal after delaying a phase of the input signal at the second terminal by 90 degrees and outputs the synthesized signal from the first terminal;

a 90/n-degree LO distributor (5), n is an integer except 0, which distributes and outputs an input signal at a first terminal from second and third terminals with a phase difference of 90/n degrees; and

a 90-degree RF synthesis distributor (6) which distributes and outputs an input signal at a first terminal from second and third terminals with a phase difference of 90 degrees and outputs from a third terminal a signal having a phase delay of 90 degrees with respect to a phase output from the second terminal, wherein:

the second terminal of the 90-degree IF synthesis distributor (4) is connected to the IF terminal of the first 4-nth -order harmonic mixer (7a);

the third terminal of the 90-degree IF synthesis distributor (4) is connected to the IF terminal of the second 4-nth -order harmonic mixer (7b);

the second terminal of the 90/n-degree LO distributor (5) is connected to the LO terminal of the first 4-nth -order harmonic mixer (7a);

the third terminal of the 90/n-degree LO distributor (5) is connected to the LO terminal of the second 4-nth -order harmonic mixer (7b);

the second terminal of the 90-degree RF synthesis distributor (6) is connected to the RF terminal of the first 4-nth -order harmonic mixer (7a); and

the third terminal of the 90-degree RF synthesis distributor (6) is connected to the RF terminal of the second 4-nth -order harmonic mixer (7b).

3. The image rejection mixer according to claim 1 or claim 2, wherein the 90/n-degree LO distributor (5) outputs from the third terminal a signal having a phase delay of 90/n degrees with respect to a phase output from the second terminal.

4. The image rejection mixer according to claim 1 or claim 2, wherein the 90/n-degree LO distributor (5) outputs from the second terminal a signal having a phase delay of 90/n degrees with respect to a phase output from the third terminal.

5. The image rejection mixer according to claim 1 or claim 2, wherein in each of the first and the second 4-nth order harmonic mixer (9a, 9b) n =1.

6. The image rejection mixer according to claim 1 or claim 2, wherein in each of the first and the second 4-nth order harmonic mixer (9a, 9b) n > 1.

7. The image rejection mixer according to claim 1 or claim 2, wherein in the 90/n-degree LO distributor (5) n = 1.

8. The image rejection mixer according to claim 1 or claim 2, wherein in the 90/n-degree LO distributor (5) n > 1.

9. A wireless communication device comprising the image rejection mixer according to any one of claims 1 to 8.

**Patentansprüche**

1. Spiegelfrequenzunterdrückungsmischer, aufweisend:

erste und zweite harmonische Mischer (7a, 7b) 4-nter Ordnung, wobei jeder einen LO-Anschluss, einen IF-Anschluss und einen RF-Anschluss enthält und als gewünschte Welle eine RF als eine gemischte Welle einer Komponente 4-nter Ordnung, wobei n eine ganze Zahl außer 0 ist, einer Eingangs-LO-Signalfrequenz und einer Komponente erster Ordnung einer IF ausgibt,

einen 90-Grad-IF-Syntheseverteiler (4), der ein Eingangssignal an einem ersten Anschluss von zweiten und dritten Anschlüssen mit einer Phasendifferenz von 90 Grad verteilt und ausgibt,

einen 90/n-Grad-LO-Verteiler (5), wobei n eine ganze Zahl außer 0 ist, der ein Eingangssignal an einem ersten Anschluss von zweiten und dritten Anschlüssen mit einer Phasendifferenz von 90/n Grad verteilt und ausgibt; und

einen 90-Grad-RF-Syntheseverteiler (6), der ein Eingangssignal an einem zweiten Anschluss mit einem Eingangssignal an einem dritten Anschluss nach Führen einer Phase des Eingangssignals an dem zweiten Anschluss um 90 Grad synthetisiert und das synthetisierte Signal von dem ersten Anschluss ausgibt, wobei:

der zweite Anschluss des 90-Grad-IF-Syntheseverteilers (4) mit dem IF-Anschluss des ersten harmonischen Mischers 4-nter Ordnung (7a) verbunden ist;

der dritte Anschluss des 90-Grad-IF-Syntheseverteilers (4) mit dem IF-Anschluss des zweiten harmonischen Mischers 4-nter Ordnung (7b) verbunden ist;

der zweite Anschluss des 90/n-Grad-LO-Verteilers (5) mit dem LO-Anschluss des ersten harmonischen Mischers 4-nter Ordnung (7a) verbunden ist;

der dritte Anschluss des 90/n-Grad-LO-Verteilers (5) mit dem LO-Anschluss des zweiten harmonischen Mischers 4-nter Ordnung (7b) verbunden ist;

der zweite Anschluss des 90-Grad-RF-Syntheseverteilers (6) mit dem RF-Anschluss des ersten harmonischen Mischers 4-nter Ordnung (7a) verbunden ist; und

der dritte Anschluss des 90-Grad-RF-Syntheseverteilers (6) mit dem RF-Anschluss des zweiten harmonischen Mischers 4-nter Ordnung (7b) verbunden ist.

2. Spiegelfrequenzunterdrückungsmischer, aufweisend:

erste und zweite harmonische Mischer 4-nter Ordnung (7a, 7b), wobei n eine ganze Zahl außer 0 ist, wobei jeder einen LO-Anschluss, einen IF-Anschluss und einen RF-Anschluss enthält, und als gewünschte Welle die IF als eine gemischte Welle einer Komponente 4-nter Ordnung, wobei n eine ganze Zahl außer 0 ist, der Eingangs-LO-Signalfrequenz und einer Komponente erster Ordnung der RF ausgibt;

einen 90-Grad-IF-Syntheseverteiler (4) der ein Eingangssignal an einem zweiten Anschluss und ein Eingangssignal an einem dritten Anschluss nach dem Verschieben einer Phase des Eingangssignals an dem zweiten Anschluss um 90 Grad synthetisiert, und das synthetisierte Signal von dem ersten Anschluss ausgibt;

einen 90/n-Grad-LO-Verteiler (5), wobei n eine ganze Zahl außer 0 ist, der ein Eingangssignal an einem ersten Anschluss von zweiten und dritten Anschlüssen mit einer Phasendifferenz von 90/n Grad verteilt und ausgibt; und

einen 90-Grad-RF-Syntheseverteiler (6), der ein Eingangssignal an einem ersten Anschluss von zweiten und dritten Anschlüssen mit einer Phasendifferenz von 90 Grad verteilt und ausgibt und von einem dritten Anschluss ein Signal, das eine Phasenverschiebung von 90 Grad bezüglich einer Phase, die von dem zweiten Anschluss ausgegeben worden ist, hat, ausgibt, wobei:

der zweite Anschluss des 90-Grad-IF-Syntheseverteilers (4) mit dem IF-Anschluss des ersten harmonischen Mischers 4-nter Ordnung (7a) verbunden ist;

der dritte Anschluss des 90-Grad-IF-Syntheseverteilers (4) mit dem IF-Anschluss des zweiten harmonischen Mischers 4-nter Ordnung (7b) verbunden ist;

der zweite Anschluss des 90/n-Grad-LO-Verteilers (5) mit dem LO Anschluss des ersten harmonischen Mischers 4-nter Ordnung (7a) verbunden ist;

der dritte Anschluss des 90/n-Grad-LO-Verteilers (5) mit dem LO-Anschluss des zweiten harmonischen Mischers 4-nter Ordnung (7b) verbunden ist;

der zweite Anschluss des 90-Grad-RF-Syntheseverteilers (6) mit dem RF-Anschluss des ersten harmonischen Mischers 4-nter Ordnung (7a) verbunden ist; und

der dritte Anschluss des 90-Grad-RF-Syntheseverteilers (6) mit dem RF-Anschluss des zweiten harmonischen Mischers 4-nter Ordnung (7b) verbunden ist.

3. Spiegelfrequenzunterdrückungsmischer nach Anspruch 1 oder Anspruch 2, wobei der 90/n-Grad-LO-Verteiler (5) von dem dritten Anschluss ein Signal ausgibt, das eine Phasenverschiebung von 90/n Grad bezüglich einer Phase, die von dem zweiten Anschluss ausgegeben worden ist, hat.

4. Spiegelfrequenzunterdrückungsmischer nach Anspruch 1 oder Anspruch 2, wobei der 90/n-Grad-LO-Verteiler (5) von dem zweiten Anschluss ein Signal mit einer Phasenverschiebung von 90/n Grad bezüglich einer Phase ausgibt, die von dem dritten Anschluss ausgegeben worden ist.

5. Spiegelfrequenzunterdrückungsmischer nach Anspruch 1 oder Anspruch 2, wobei in jedem des ersten und des zweiten harmonischen Mischers (9a, 9b) 4-nter Ordnung n = 1 ist.

6. Spiegelfrequenzunterdrückungsmischer nach Anspruch 1 oder Anspruch 2, wobei in jedem des ersten und des zweiten harmonischen Mischers 4-nter Ordnung (9a, 9b) n > 1 ist.

7. Spiegelfrequenzunterdrückungsmischer nach Anspruch 1 oder Anspruch 2, wobei in dem 90/n-Grad-LO-Verteiler (5) n = 1 ist.

8. Spiegelfrequenzunterdrückungsmischer nach Anspruch 1 oder Anspruch 2, wobei in dem 90/n-Grad-LO-Verteiler (5) n > 1 ist.

9. Drahtloses Kommunikationsgerät, aufweisend den Spiegelfrequenzunterdrückungsmischer nach einem der Ansprüche 1 bis 8.

**Revendications**

1. Mélangeur à réjection simple, comprenant :

   des premier et deuxième mélangeurs d'harmoniques du 4 $n^{ième}$ ordre (7a, 7b), comprenant chacun une borne LO, une borne IF et une borne RF, et délivrant en sortie, en tant qu'onde souhaitée, une RF en tant qu'onde mélangée d'une composante du $4n^{ième}$ ordre, n étant un nombre entier différent de 0, d'une fréquence du signal LO d'entrée et d'une composante du premier ordre d'une IF ;
   un distributeur de synthèse IF à 90 degrés (4) qui distribue et délivre en sortie un signal d'entrée au niveau d'une première borne à partir des deuxième et troisième bornes avec une différence de phase de 90 degrés ;
   un distributeur LO à 90/n degrés (5), n étant un nombre entier différent de 0, qui distribue et délivre en sortie un signal d'entrée au niveau d'une première borne à partir des deuxième et troisième bornes avec une différence de phase de 90/n degrés ; et
   un distributeur de synthèse RF à 90 degrés (6) qui synthétise un signal d'entrée au niveau d'une deuxième borne avec un signal d'entrée au niveau d'une troisième borne après avoir mené la phase du signal d'entrée au niveau de la deuxième borne de 90 degrés et délivre en sortie le signal synthétisé à partir de la première borne, dans lequel :

      la deuxième borne du distributeur de synthèse IF à 90 degrés (4) est reliée à la borne IF du premier mélangeur d'harmoniques du 4 $n^{ième}$ ordre (7a) ;
      la troisième borne du distributeur de synthèse IF à 90 degrés (4) est reliée à la borne IF du deuxième mélangeur d'harmoniques du 4 $n^{ième}$ ordre (7b) ;
      la deuxième borne du distributeur LO à 90/n degrés (5) est reliée à la borne LO du premier mélangeur d'harmoniques du 4 $n^{ième}$ ordre (7a) ;
      la troisième borne du distributeur LO à 90/n degrés (5) est reliée à la borne LO du deuxième mélangeur d'harmoniques du 4 $n^{ième}$ ordre (7b) ;
      la deuxième borne du distributeur de synthèse RF à 90 degrés (6) est reliée à la borne RF du premier mélangeur d'harmoniques du 4 $n^{ième}$ ordre (7a) ; et
      la troisième borne du distributeur de synthèse RF à 90 degrés (6) est reliée à la borne RF du deuxième mélangeur d'harmoniques du 4 $n^{ième}$ ordre (7b).

2. Mélangeur à réjection simple, comprenant :

   des premier et deuxième mélangeurs d'harmoniques du 4 $n^{ième}$ ordre (7a, 7b), n étant un nombre entier différent de 0, comprenant chacun une borne LO, une borne IF et une borne RF, et délivrant en sortie, en tant qu'onde souhaitée, une IF en tant qu'onde mélangée d'une composante du $4^{nième}$ ordre, n étant un nombre entier différent de 0, de la fréquence du signal LO d'entrée et d'une composante du premier ordre de la RF ;
   un distributeur de synthèse IF à 90 degrés (4) qui synthétise un signal d'entrée au niveau d'une deuxième borne et un signal d'entrée au niveau d'une troisième borne après avoir retardé la phase du signal d'entrée au niveau de la deuxième borne de 90 degrés et délivre en sortie le signal synthétisé à partir de la première borne ;
   un distributeur LO à 90/n degrés (5), n étant un nombre entier différent de 0, qui distribue et délivre en sortie un signal d'entrée au niveau d'une première borne à partir des deuxième et troisième bornes avec une différence de phase de 90/n degrés ; et
   un distributeur de synthèse RF à 90 degrés (6) qui distribue et délivre en sortie un signal d'entrée au niveau d'une première borne à partir des deuxième et troisième bornes avec une différence de phase de 90 degrés et délivre en sortie à partir d'une troisième borne un signal présentant un retard de phase de 90 degrés par rapport à une phase délivrée en sortie par la deuxième borne, dans lequel :

      la deuxième borne du distributeur de synthèse IF à 90 degrés (4) est reliée à la borne IF du premier mélangeur d'harmoniques du 4 $n^{ième}$ ordre (7a) ;
      la troisième borne du distributeur de synthèse IF à 90 degrés (4) est reliée à la borne IF du deuxième mélangeur d'harmoniques du 4 $n^{ième}$ ordre (7b) ;

la deuxième borne du distributeur LO à 90/n degrés (5) est reliée à la borne LO du premier mélangeur d'harmoniques du 4 $n^{ième}$ ordre (7a) ;

la troisième borne du distributeur LO à 90/n degrés (5) est reliée à la borne LO du deuxième mélangeur d'harmoniques du 4 $n^{ième}$ ordre (7b) ;

la deuxième borne du distributeur de synthèse RF à 90 degrés (6) est reliée à la borne RF du premier mélangeur d'harmoniques du 4 $n^{ième}$ ordre (7a) ; et

la troisième borne du distributeur de synthèse RF à 90 degrés (6) est reliée à la borne RF du deuxième mélangeur d'harmoniques du 4 $n^{ième}$ ordre (7b).

3. Mélangeur à réjection simple selon la revendication 1 ou la revendication 2, dans lequel le distributeur LO à 90/n degrés (5) délivre en sortie à partir de la troisième borne un signal présentant un retard de phase de 90/n degrés par rapport à une phase délivrée en sortie par la deuxième borne.

4. Mélangeur à réjection simple selon la revendication 1 ou la revendication 2, dans lequel le distributeur LO à 90/n degrés (5) délivre en sortie à partir de la deuxième borne un signal présentant un retard de phase de 90/n degrés par rapport à une phase délivrée en sortie par la troisième borne.

5. Mélangeur à réjection simple selon la revendication 1 ou la revendication 2, dans lequel, dans chacun des premier et deuxième mélangeurs d'harmoniques du 4 $n^{ième}$ ordre (9a, 9b), n = 1.

6. Mélangeur à réjection simple selon la revendication 1 ou la revendication 2, dans lequel, dans chacun des premier et deuxième mélangeurs d'harmoniques du 4 $n^{ième}$ ordre (9a, 9b), n > 1.

7. Mélangeur à réjection simple selon la revendication 1 ou la revendication 2, dans lequel, dans le distributeur LO à 90/n degrés (5), n = 1.

8. Mélangeur à réjection simple selon la revendication 1 ou la revendication 2, dans lequel, dans le distributeur LO à 90/n degrés (5), n > 1.

9. Dispositif de communication sans fil comprenant le mélangeur à réjection simple selon l'une quelconque des revendications 1 à 8.

FIG. 1

# FIG. 2

# FIG. 3

# FIG. 4

# FIG. 5

EP 2 187 517 B1

# FIG. 6

EP 2 187 517 B1

# FIG. 7

EP 2 187 517 B1

# FIG. 8

IF → MIXER [10] → BAND PASS FILTER [11] → AMPLIFIER [12] → ANTENNA [13]

LO SOURCE [14] → MIXER

EP 2 187 517 B1

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

*   JP 2003163601 A

**Non-patent literature cited in the description**

*   Monolithic microwave integrated circuit. **MASAY-OSHI AIKAWA ; TAKASHI OHIRA ; TSUNEO TOKUMITSU ; TETSUO HIROTA ; MASHIRO MU-RAGUCHI.** The Institute of Electronics, Information and Communication Engineers. 25 January 1995, 118-119120-122